# EUROPEAN PATENT APPLICATION

(11) **EP 1 233 526 A1**
(43) Date of publication of application: **21.08.2002**
(21) Application number: 01958452.3
(22) Date of filing: 24.08.2001
(51) Int. Cl.: H04B 1/30, H04L 27/14, H04L 27/22

(54) **DIRECT CONVERSION RECEIVER**

(30) Priority: 28.08.2000 JP 2000256764
(71) Applicant: MATSUSHITA ELECTRIC INDUSTRIAL CO., LTD., Kadoma-shi, Osaka 571-8501 (JP)
(72) Inventor: ADACHI, Yasuhiro, Yokosuka-shi, Kanagawa 239-0847 (JP)
(74) Representative: Grünecker, Kinkeldey, Stockmair & Schwanhäusser Anwaltssozietät
(86) International application number: JP0107242
(87) International publication number: WO02019553

(57) **Abstract**

In a direct-conversion receiving apparatus it is possible to prevent unnecessary emission from an antenna as well as deterioration of the error rate characteristics caused by DC offsets, a power dividing unit 104 divides an RF signal amplified in an RF amplifier 103 into four signals of first through fourth RF signals, phase-shifters 105-107 shift the phases of the second through fourth RF signals by 180°, 90° and 270°, respectively and mixers 108-111 generate first through fourth baseband signals by mixing the first RF signal and second through fourth RF signals after phase-shifting with local signals from a local oscillator 112, respectively.

## Description

### Technical Field

The present invention relates to a receiving apparatus using a direct-conversion receiving method by which a received frequency is directly converted into a baseband frequency.

### Background Art

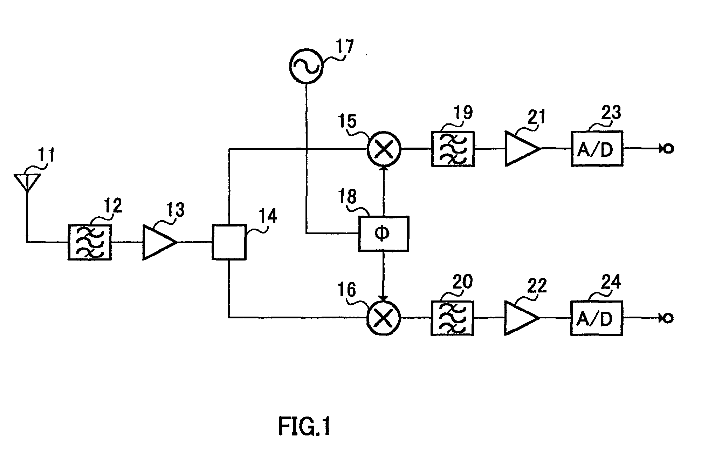

A direct-conversion receiving method is a receiving method that performs detection by direct frequency conversion of a received RF signal (radio frequency signal) into a baseband signal by mixing the received signal and a local signal having the same frequency as that of the received signal in a mixer. This direct-conversion receiving method has no use for an intermediate frequency (IF) circuit such as an IF filter and is suitable for IC structures in comparison with a super heterodyne receiving method which has been currently a main receiving method, so that it has been expected as a receiving method suitable for reducing size, power consumption, and cost of a receiver. Hereinafter, a receiving apparatus to which a conventional direct-conversion receiving method is applied (hereinafter, simply referred to as "direct-conversion receiving apparatus") will be described with reference to FIG. 1. FIG. 1 is a block diagram showing a configuration of a conventional direct-conversion receiving apparatus.

An RF signal received through an antenna 11 passes through an RF band-pass filter 12, is amplified in an RF amplifier 13, and then is divided into two signals in a power dividing unit 14.

On the other hand, a local signal (Lo signal) supplied from a local oscillator 17 is sent to mixers 15 and 16 after being divided in a 90° divider 18. Here, local signals sent to mixers 15 and 16 are assumed to be signals between which there is a phase difference of 90°.

Each signal divided in the power dividing unit 14 is frequency converted into a baseband signal in the respective mixers 15 and 16 by being mixed with the local signals from the 90° divider 18. Therefore, the baseband signals obtained in the mixers 15 and 16 become signals between which there is a phase difference of 90°.

Each baseband signal obtained in the respective mixers 15 and 16 passes through a low-pass filter 19, 20, is amplified in a baseband amplifier 21, 22, and then is subjected to a sampling processing in an analog to digital (A/D) converter 23, 24, respectively. The respective baseband signals of an I (in-phase) component and a Q (quadrature) component after the sampling processing in the A/D converters 23 and 24 are sent to a digital signal processing circuit and so on.

The direct-conversion receiving method has no use for an IF circuit as just described, so that it can be said to be a method suitable for reducing size, power consumption, and cost of a receiver.

However, the aforementioned conventional direct-conversion receiving apparatus has the following problems. A local signal from the local oscillator 17 might leak to the BB ports and RF ports since the isolation between Lo-RF ports and Lo-BB ports in each mixer 15 and 16 is not complete. Here, the BB ports correspond to the ports at the side of the low-pass filters 19 and 20 and RF ports correspond to the ports at the side of the power dividing unit 14.

Since the local signal leaked to the BB ports is eliminated in both low-pass filters 19 and 20, it does not pose a problem. But the local signal which has leaked to the RF ports poses a problem, since the frequency of the local signal is equivalent to that of the received signal.

That is, firstly the local signal which has leaked to the RF ports is emitted from antenna 11 after passing through RF band-pass filter 12, as the frequency of the local signal is equivalent to that of a desired signal. Therefore, the radio wave emitted from antenna 11 as described above becomes an unnecessary emission and becomes an interfering wave to other terminals.

Secondly, the local signal which has leaked to the RF ports is inputted to mixer 15 or 16 after being reflected at the power dividing unit 14, RF amplifier 13, or RF band-pass filter 12. Therefore, self detection is performed in mixer 15 or 16 by multiplication of the local signal from the 90° divider 18 by the input local signal after being reflected.

When self detection is executed in the mixers 15 and 16, DC offsets which represent direct-current components are outputted to the low-pass filters 19 and 20, respectively. That is to say, the DC offsets are added to the baseband signals obtained from the mixer 15 and 16, respectively. As a result, the voltages of the baseband signals obtained from mixers 15 and 16 are increased or decreased based on the effects of the DC offsets. The voltage variations according to the DC offsets become a problem at the aforementioned analog to digital conversion.

Therefore, the present receiving apparatus suppresses receiving sensitivity and deteriorates the receiving error rate characteristics due to the DC offsets caused by self detection in mixers 15 and 16 when the local signal leaks to the RF port.

As described above, there are problems in a conventional direct-conversion receiving apparatus that an unnecessary emission from the antenna is occurred and the error rate characteristics are deteriorated by the DC offsets based on leakage of the local signals.

In order to prevent the above problems, a method has been disclosed in the prior Japanese Patent Application HEI-6 (1994) - 268546 wherein, a received RF signal is divided to four signals in a power dividing unit and each divided RF signal passes through 0°, 90°, 180° and 270° phase-shifters , respectively. According to this configuration, the phase differences of 0°, 90°, 180° and 270° are given to local signals leaked from the mixers into the antenna side, respectively. Thereby, the leaked local signals cancel each other when they are added in the power dividing unit. Therefore, unnecessary emission of local signals from an antenna may be prevented.

However, the generation of DC offsets may not be prevented by this method, though the unnecessary emission from an antenna may be prevented. That is, there is a case in which local signals leaked from mixers to the antenna side are inputted to the mixers after the signals are reflected at the power dividing unit and phase-shifters. Thereby, the DC offsets are generated in the mixers since self detection is performed.

### Disclosure of Invention

The object of the present invention is to provide a direct-conversion receiving apparatus which prevents unnecessary emission from an antenna and deterioration of the error rates characteristics caused by the DC offsets.

According to an aspect of the present invention, a direct-conversion receiving apparatus comprises dividing means for dividing a high frequency signal received through an antenna into two signals, a first signal and a second signal, converting means for generating a first baseband signal from the first signal and a second baseband signal from the second signal, respectively, by frequency conversion of the first signal and the second signal using local signals with the same frequency as that of each of the first signal and the second signal so that there is an anti-phase relation between the first baseband signal and the second baseband signal, and adding means for generating a baseband signal of a predetermined channel by taking a difference between the first baseband signal and the second baseband signal.

According to another aspect of the present invention, a direct-conversion receiving apparatus comprises converting means for generating a baseband signal of a predetermined channel by frequency conversion of a high frequency signal received through an antenna using a local signal with the same frequency as that of the high frequency signal, generating means for compulsory generating DC offset using the local signal, and adding means for subtracting the DC offset from the baseband signal of a predetermined channel.

### Brief Description of Drawings

FIG. 1 is a block diagram showing a configuration of a conventional direct-conversion receiving apparatus;
FIG. 2 is a block diagram showing a configuration of a direct-conversion receiving apparatus according to embodiment 1 of the present invention;
FIG. 3 is a block diagram showing a configuration of a direct-conversion receiving apparatus according to embodiment 2 of the present invention;
FIG. 4 is a block diagram showing a configuration of a direct-conversion receiving apparatus according to embodiment 3 of the present invention;
FIG. 5 is a block diagram showing a configuration of a direct-conversion receiving apparatus according to embodiment 4 of the present invention;
FIG. 6 is a block diagram showing a configuration of a direct-conversion receiving apparatus according to embodiment 5 of the present invention;
FIG. 7 is a block diagram showing a configuration of a direct-conversion receiving apparatus according to embodiment 6 of the present invention;
FIG. 8 is a block diagram showing a configuration of a direct-conversion receiving apparatus according to embodiment 7 of the present invention; and
FIG. 9 is a block diagram showing a configuration of a direct-conversion receiving apparatus according to embodiment 8 of the present invention.

### Best Mode for Carrying Out the Invention

Embodiments of the present invention will be described below specifically with reference to accompanying drawings.

### (Embodiment 1)

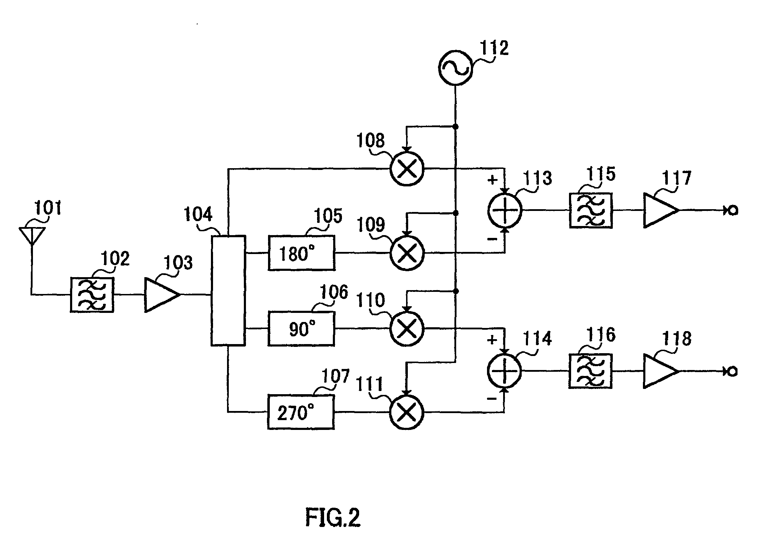

FIG. 2 is a block diagram showing a configuration of a direct-conversion receiving apparatus according to embodiment 1 of the present invention. In FIG. 2, a band-pass filter 102 outputs only a signal of a desired frequency band among RF signals (radio frequency signals) received through an antenna 101 to an RF amplifier. The RF amplifier 103 amplifies the RF signal of the desired frequency band obtained from the band-pass filter 102 to output the RF signal to a power dividing unit 104.

The power dividing unit 104 divides the RF signal amplified in the RF amplifier 103 into four signals to output the divided RF signals to a mixer 108 and phase-shifters 105, 106 and 107.

The phase-shifter 105 shifts the phase of the RF signal from the power dividing unit 104 by 180° and outputs the RF signal to a mixer 109. The phase-shifter 106 shifts the phase of the RF signal from the power dividing unit 104 by 90° and outputs the RF signal to a mixer 110. The phase-shifter 107 shifts the phase of the RF signal from the power dividing unit 104 by 270° and outputs the RF signal to a mixer 111.

A local oscillator 112 generates a local signal of the same frequency as that of the desired RF signal and outputs the local signal to each mixer 108-111. The mixer 108 generates a baseband signal by frequency conversion of the RF signal from the power dividing unit 104 through mixing the RF signal from the power dividing unit 104 and the local signal from the local oscillator 112. Similarly, the mixers 109, 110 and 111 generate baseband signals by frequency conversion of the RF signals from the phase-shifters 105, 106 and 107, respectively, through mixing the RF signals from the phase-shifters 105, 106 and 107 and the local signal from the local oscillator 112.

An adder 113 outputs a difference between the baseband signal obtained from mixer 108 and the baseband signal obtained from mixer 109 to a low-pass filter 115. Similarly, an adder 114 outputs a difference between the baseband signal obtained from mixer 110 and the baseband signal obtained from mixer 111 to a low-pass filter 116.

The low-pass filters 115 and 116, after cancellation of high frequency noise, output the baseband signals from adders 113 and 114 to baseband amplifiers 117 and 118, respectively.

Next, operation of the direct-conversion receiving apparatus having the above configuration will be described. The RF signal received through antenna 101 becomes the RF signal of the desired frequency band after passing through the band-pass filter 102. After the RF signal of the desired frequency band is amplified in the RF amplifier 103, the RF signal is divided into four RF signals (hereinafter, referred to as "first RF signal", "second RF signal", "third RF signal" and "fourth RF signal") in the power dividing unit 104. The first through fourth RF signals are outputted to mixer 108, phase-shifter 105, phase-shifter 106 and phase-shifter 107, respectively.

After the phases of the second through fourth RF signals are shifted by 180°, 90° and 270° in the phase-shifters 105-107, respectively, the second through fourth RF signals are outputted to mixers 109-111, respectively.

The local signal generated in the local oscillator 112 is inputted to the mixers 108-111. In mixers 108-111, the local signal outputted from the local oscillator 112 and the RF signals after being phase-shifted in the corresponding phase-shifters 105-107 are mixed, respectively. Thereby, the first RF signal and the second through fourth RF signals after phase-shifting become the first through fourth baseband signals after frequency conversion into baseband, respectively. The first and second baseband signals are outputted to the adder 113 whereas the third and fourth baseband signals are outputted to the adder 114.

At this time, there is an anti-phase relation between the first baseband signal and the second baseband signal since the phase of the second RF signal has been shifted by 180°. Similarly, there is an anti-phase relation between the third baseband signal and the fourth baseband signal since the phase of the fourth RF signal has been shifted by 270°.

In the adder 113, the difference between the first baseband signal and second baseband signal is obtained. That is, the second baseband signal is subtracted from first baseband signal. Here, an in-phase addition of the first baseband signal to second baseband signal is performed in the adder 113since there is an anti-phase relation between the first baseband signal and second baseband signal. Thereby, an I-ch baseband signal is generated in the adder 113.

In the adder 114, the difference between the third baseband signal and fourth baseband signal is obtained. That is, the fourth baseband signal is subtracted from third baseband signal. Here, in-phase addition of the third baseband signal to fourth baseband signal is performed in the adder 114 since there is an anti-phase relation between the third baseband signal and fourth baseband signal. Thereby, a Q-ch baseband signal is generated in the adder 114.

Therefore, it is obvious that there is a phase difference of 90° between the I-ch baseband signal and Q-ch baseband signal because the phase of the third RF signal is shifted from that of the first RF signal by 90°.

Both I-ch baseband signal and Q-ch baseband signal are amplified in the baseband amplifiers 117 and 118, respectively, after cancelling each of the high frequency noise in both baseband signals in the low-pass filters 115 and 116, respectively. The I-ch baseband signal and Q-ch baseband signal which have been amplified are outputted to a digital signal processing circuit after sampling processing in not shown analog to digital converters.

Then, while paying special attention to the local signals which have been leaked to mixers 108-111, operation of the direct-conversion receiving apparatus having the above configuration will be described. In a similar manner to that of a conventional one, there is a possibility that the local signal from the local oscillator 112 leaks to the mixers 108-111 even in the direct-conversion receiving apparatus according to the present embodiment.

A local signal leaked to the RF port in mixer 108 reaches the power dividing unit 104 without phase-shifting. A local signal leaked to the RF port in mixer 109 reaches the power dividing unit 104 after being phase shifted by 180° in the phase-shifter 105. Therefore, the local signal from mixer 108 and local signal from mixer 109 cancel each other by their addition in the power dividing unit 104 as there is an anti-phase relation between them at the time when they reach the power dividing unit 104.

Similarly, a local signal leaked to the RF port in mixer 110 reaches the power dividing unit 104 after being phase shifted by 90° in the phase-shifter 106. A local signal leaked to the RF port in mixer 111 reaches the power dividing unit 104 after being phase shifted by 270° in the phase-shifter 107. Therefore, the local signal from mixer 110 and local signal from mixer 111 cancel each other by their addition in the power dividing unit 104 as there is an anti-phase relation between them at the time when they reach the power dividing unit 104. Thereby, unnecessary emission from the antenna caused by leakage of local signals may be remarkably suppressed.

As described above, the local signals which have leaked to mixers 108-111 are almost completely cancelled in the power dividing unit 104 by provision of the phase-shifters 105 through 107.

However, there is a case in which the local signal that has leaked to mixer 108 is input to mixer 108 after the local signal is reflected in the power dividing unit 104 before being cancelled therein. Moreover, there is a case in which the local signal that has leaked to mixer 109 is input to mixer 109 after the signal is reflected in the phase-shifter 105 or in power dividing unit 104 before being cancelled in the power dividing unit 104. Similarly, there is a case in which the local signals that have leaked to mixers 110 and 111 are input to the aforementioned mixers 110 and 111, respectively, after the local signals are reflected in the power dividing unit 104 or in phase-shifters 105 and 107, respectively, before being cancelled in the power dividing unit 104.

Specifically, the local signal which has leaked to mixer 108 is input to mixer 108 again after the local signal is reflected in the power dividing unit 104 without phase-shifting.

The local signal which has leaked to mixer 109 is input to mixer 109 again after being phase shifted by 180° in the phase-shifter 105, the local signal is reflected in the power dividing unit 104 and the phase of the local signal is shifted again by 180 degrees in the phase-shifter 105. In other words, the local signal which has leaked to mixer 109 is input to mixer 109 after being reflected in the power dividing unit 105. That is, there is an in-phase relation between the local signal which has leaked to mixer 109 and the reflected local signal.

Similarly, the local signal which has leaked to mixer 110 (mixer 111) is input to mixer 110 (mixer 111) again after the phase of the local signal is shifted by 90° (270°) in the phase-shifter 106 (phase-shifter 107), the local signal is reflected in the power dividing unit 104 and the phase of the local signal is shifted again by 90° (270°) in the phase-shifter 106 (phase-shifter 107). In other words, the local signal which has leaked to mixer 110 (mixer 111) is input to mixer 110 (mixer 111) after being reflected in the phase-shifter 106 (phase-shifter 107). That is, there is an anti-phase relation between the local signal which has leaked to mixer 110 (mixer 111) and the reflected local signal.

Then, in mixers 108-111, self detection is performed by mixing the local signal after the reflection and local signal from the local oscillator 112, consequently, DC offsets are generated. Here, there is an in-phase relation between the DC offset generated in mixer 108 and DC offset generated in mixer 109. Similarly, there is an in-phase relation between the DC offset generated in mixer 110 and DC offset generated in the mixer 111.

Though DC offsets are generated in mixers 108-111 as described above, the DC offset generated in mixer 109 is subtracted from DC offset generated in mixer 108 in the adder 113. Therefore, there is elimination of the DC offset in the I-ch baseband signal generated in adder 113. Similarly, the DC offset generated in mixer 111 is subtracted from DC offset generated in mixer 110 in the adder 114. Therefore, the DC offset is eliminated from the Q-ch baseband signal generated in adder 114. Thereby, deterioration of the error rate characteristics caused by the DC offsets may be remarkably prevented.

As mentioned above, in the present embodiment, a received signal (radio frequency signal) is firstly divided into two signals of a first signal and second signal, and frequency conversion of the first signal and second signal is performed so that there is an anti-phase relation between the baseband signal obtained from the first signal and baseband signal obtained from the second signal, when baseband signals are generated by frequency conversion of the received signal. Moreover, subtraction processing to subtract the two baseband signals which have an anti-phase relation from each other is performed.

Thereby, the baseband signals between which there is an anti-phase relation appropriately become predetermined baseband signals since an in-phase addition of the baseband signals is performed. On the other hand, the DC offset which might be generated at frequency conversion of the first signal and DC offset which might be generated at frequency conversion of the second signal cancel each other in the above subtraction processing since there is an in-phase relation between them. Thereby, deterioration of the error rate characteristics caused by DC offsets may be prevented.

In addition, according to the present embodiment, the local signal which leaks to the RF port at frequency conversion of the first signal and the local signal which leaks to the RF port at frequency conversion of the second signal, both cancel each other at the side of the RF port as there is an anti-phase relation between them. Thereby, unnecessary emission from the antenna may be prevented.

### (Embodiment 2)

In the present embodiment, a description is given to the case in which the dispersion of the characteristics of the phase-shifters are suppressed by reducing the number of kinds of the phase-shifters which have been used in embodiment 1.

In the aforementioned embodiment 1, three kinds of phase-shifters for phase-shifting by 90°, 180° and 270° have been used as phase-shifters. As many kinds of the used phase-shifters as large possibility to have deterioration of the received signals characteristics that is caused by the dispersion of the characteristics in each phase-shifter.

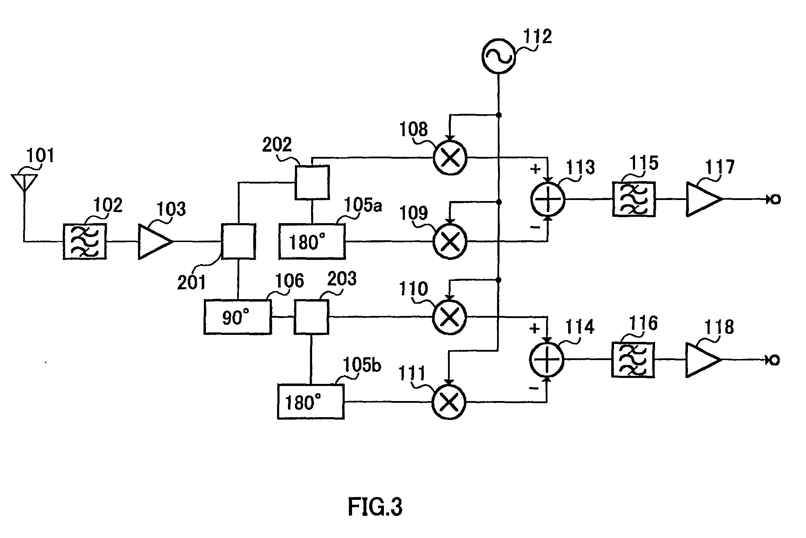

Therefore, only two kinds of phase-shifters for phase-shifting by 90° and 180° are used in the present embodiment. Next, a direct-conversion receiving apparatus according to the present embodiment will be described with reference to FIG. 3.

FIG. 3 is a block diagram showing a configuration of the direct-conversion receiving apparatus according to embodiment 2 of the present invention. In Fig. 3, the components similar to those corresponding to embodiment 1 shown in FIG. 2 are assigned the same reference numerals and detailed descriptions thereof are omitted.

In FIG. 3, a power dividing unit 201 divides an RF signal amplified in an RF amplifier 103 into two signals and outputs the divided RF signals to a power dividing unit 202 and a phase-shifter 106. The power dividing unit 202 divides the RF signal from the power dividing unit 201 into two signals and outputs the divided RF signals to both mixer 108 and phase-shifter 105a. The power dividing unit 203 divides the RF signal being phase-shifted by 90° in the phase-shifter 106 into two signals and outputs the divided RF signals to both mixer 110 and a phase-shifter 105b.

Then, operation of the direct-conversion receiving apparatus having the above configuration will be described. In the present embodiment, the detailed description of the operations similar to those of embodiment 1 will be omitted.

The RF signal amplified in the RF amplifier 103 is divided into two RF signals (hereinafter, referred to as "fifth RF signal" and "sixth RF signal") in the power dividing unit 201. The fifth RF signal is outputted to the power dividing unit 202 whereas the sixth RF signal is outputted to the phase-shifter 106.

The fifth RF signal is divided into two RF signals (hereinafter, referred to as "seventh RF signal" and "eighth RF signal") in the power dividing unit 202. The seventh RF and the eighth RF signals are processed in mixers 108 and 109, respectively, in a similar manner to that of embodiment 1. Here, there is an anti-phase relation between the seventh RF signal inputted to mixer 108 and the eighth RF signal inputted to mixer 109, in a similar manner to that of embodiment 1.

The sixth RF signal being phase shifted by 90° in phase-shifter 106 is divided into two RF signals (hereinafter, referred to as "ninth RF signal" and "tenth RF signal" ) in the power dividing unit 203. The ninth RF signal is outputted to mixer 110 whereas the tenth RF signal being phase shifted by 180° in phase-shifter 105b is outputted to mixer 111 . The ninth and tenth RF signals are processed in mixers 110 and 111, respectively, in a similar manner to that of embodiment 1. Here, there is an anti-phase relation between the ninth RF signal inputted to mixer 110 and the tenth RF signal inputted to mixer 111, in a similar manner to that of embodiment 1.

According to the above configuration, an I-ch baseband signal is generated in an adder 113 by in-phase addition of the first baseband signal and second baseband signal. In addition, a Q-ch baseband signal is generated in an adder 114 by in-phase addition of the third baseband signal and fourth baseband signal.

Moreover, the local signal which has leaked to mixer 108 reaches the power dividing unit 202 without phase-shifting. The local signal which has leaked to mixer 109 reaches the power dividing unit 202 after being phase shifted by 180° in the phase-shifter 105a. Therefore, the local signal from mixer 108 and local signal from mixer 109 cancel each other by their addition in the power dividing unit 202 as there is an anti-phase relation between them at the time when they reach the power dividing unit 202.

Similarly, the local signal which has leaked to mixer 110 reaches the power dividing unit 203 without phase-shifting whereas the local signal which has leaked to mixer 111 reaches the power dividing unit 203 after being phase shifted by 180° in the phase-shifter 105b. Therefore, the local signal from mixer 110 and local signal from mixer 111 cancel each other by their addition in the power dividing unit 203 as there is an anti-phase relation between them at the time when they reach the power dividing unit 203. Thereby, unnecessary emission from an antenna caused by leakage of the local signal may be remarkably suppressed.

Moreover, if DC offsets are generated in mixers 108-111, there is an in-phase relation between a DC offset generated in mixer 108 and DC offset generated in mixer 109. Therefore, DC offsets in the I-ch baseband signal are cancelled in the adder 113 by subtracting the DC offset generated in mixer 109 from DC offset generated in mixer 108.

Similarly, there is an in-phase relation between a DC offset generated in mixer 110 and DC offset generated in mixer 111. Therefore, DC offsets in the Q-ch baseband signal are cancelled in the adder 114 by subtracting the DC offset generated in mixer 111 from DC offset generated in mixer 110. Thereby, deterioration of the error rate characteristics caused by DC offsets may be remarkably prevented.

According to the present embodiment, deterioration of the error rate characteristics caused by the DC offsets and unnecessary emission from antenna may be prevented, and deterioration of the received signals characteristics caused by the dispersion of the characteristics in phase-shifters may be suppressed. In comparison with embodiment 1 in which three kinds of phase-shifters have been used, only two kinds of phase-shifters for phase-shifting by 90° and 180° are used in embodiment 2.

### (Embodiment 3)

In the present embodiment, a case in which the phase of a local signal is shifted instead of phase-shifting of an RF signal as in embodiment 1 or 2 will be described.

In embodiment 1 or 2, phase-shifting of RF signals has been performed, using phase-shifters. However, delay in RF signals occurs in case of RF signals phase-shifting which cause deterioration of receiving quality or complex processing needed to compensate for the occurred delay.

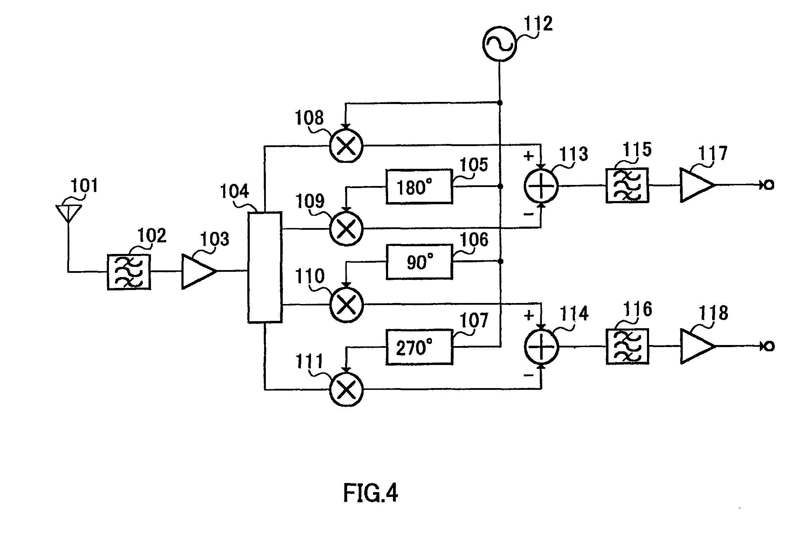

In the present embodiment, the phases of local signals are shifted instead of phase-shifting of RF signals. Hereinafter, with reference to Fig. 4, a direct-conversion receiving apparatus according to the present embodiment will be described.

FIG. 4 is a block diagram showing a configuration of the direct-conversion receiving apparatus according to embodiment 3 of the present invention. In Fig. 4, the components similar to those corresponding to embodiment 1 shown in FIG. 2 are assigned the same reference numerals and detailed descriptions thereof are omitted.

A power dividing unit 104 divides an RF signal amplified in an RF amplifier 103 into four signals and outputs the divided RF signals to corresponding mixers 108-111. A phase-shifter 105 shifts by 180° the phase of a local signal which has been generated by a local oscillator 112 and outputs the local signal to mixer 109. A phase-shifter 106 shifts by 90° the phase of the local signal which has been generated in the local oscillator 112 and outputs the local signal to mixer 110. A phase-shifter 107 shifts by 270° the phase of the local signal which has been generated by the local oscillator 112and outputs the local signal to mixer 111.

Next, operation of the direct-conversion receiving apparatus having the above configuration will be described. In the present embodiment, the detailed description of the operations similar to those of embodiment 1 will be omitted.

The RF signal amplified in the RF amplifier 103 is divided into four RF signals (first through fourth RF signals) in the power dividing unit 104. The first through fourth RF signals are outputted to mixers 108-111, respectively.

The local signal which has been generated by the local oscillator 112 is outputted without phase-shifting to mixer 108, outputted to mixer 109 after being phase shifted by 180° in the phase-shifter 105, outputted to mixer 110 after being phase shifted by 90° in the phase-shifter 106 and outputted to mixer 111 after being phase shifted by 270° in the phase-shifter 107.

The mixer 108 mixes the first RF signal and the local signal without phase-shifting while mixer 109 mixes the second RF signal and the local signal after being 180°phase-shifted, accordingly, both first and second baseband signals are generated, respectively. There is an anti-phase relation between the first baseband signal and second baseband signal.

On the other hand, the mixer 110 mixes the third RF signal and the local signal after being 90°phase-shifted while mixer 111 mixes the fourth RF signal and the local signal after being 270° phase-shifted, accordingly, both third and fourth baseband signals are generated, respectively. There is an anti-phase relation between the third baseband signal and fourth baseband signal.

In an adder 113, the difference between the first baseband signal and second baseband signal is obtained. That is, the second baseband signal is subtracted from first baseband signal. Here, in-phase addition of the first baseband signal to second baseband signal is performed in adder 113 since there is an anti-phase relation between the first baseband signal and second baseband signal. Thereby, an I-ch baseband signal is generated in adder 113.

In an adder 114, however, the difference between the third baseband signal and the fourth baseband signal is obtained. That is, the fourth baseband signal is subtracted from third baseband signal. Here, in-phase addition of the third baseband signal to fourth baseband signal is performed in adder 114 since there is an anti-phase relation between the third baseband signal and fourth baseband signal. Thereby, a Q-ch baseband signal is generated in adder 114.

Furthermore, the local signal which has leaked to mixer 108 and local signal which has leaked to mixer 109 cancel each other by their addition in the power dividing unit 104 as long as there is an anti-phase relation between them at the time when they reach the power dividing unit 104 because of an anti-phase relation between the local signal inputted to the mixer 108 and local signal inputted to the mixer 109.

Similarly, the local signal which has leaked to mixer 110 and local signal which has leaked to mixer 111 cancel each other by their addition in the power dividing unit 104 as long as there is an anti-phase relation between them at the time when they reach the power dividing unit 104 because of an anti-phase relation between the local signal inputted to mixer 110 and local signal inputted to mixer 111. Thereby, unnecessary emission from an antenna caused by the leakage of local signals may be remarkably suppressed.

Moreover, if DC offsets are generated in mixers 108-111, there is an in-phase relation between the DC offset generated in mixer 108 and DC offset generated in mixer 109. Therefore, DC offsets in an I-ch baseband signal are cancelled in adder 113 by subtracting the DC offset generated in mixer 109 from DC offset generated in mixer 108.

Similarly, there is an in-phase relation between the DC offset generated in mixer 110, and DC offset generated in mixer 111. Therefore, DC offsets in a Q-ch baseband signal are cancelled in adder 114 by subtracting the DC offset generated in mixer 112 from DC offset generated in mixer 110. Thereby, deterioration of the error rate characteristics caused by DC offsets may be remarkably prevented.

According to the present embodiment, deterioration of the error rate characteristics caused by DC offsets and unnecessary emission from the antenna may be prevented, and deterioration of the receiving quality and complex processing which have been caused by the phase-shifting of the RF signals may be suppressed comparing to embodiment 1 or 2 in which the phases of the RF signals have been used, in embodiment 3, the phase of the local signals has been shifted instead of phase-shifting of the RF signals.

### (Embodiment 4)

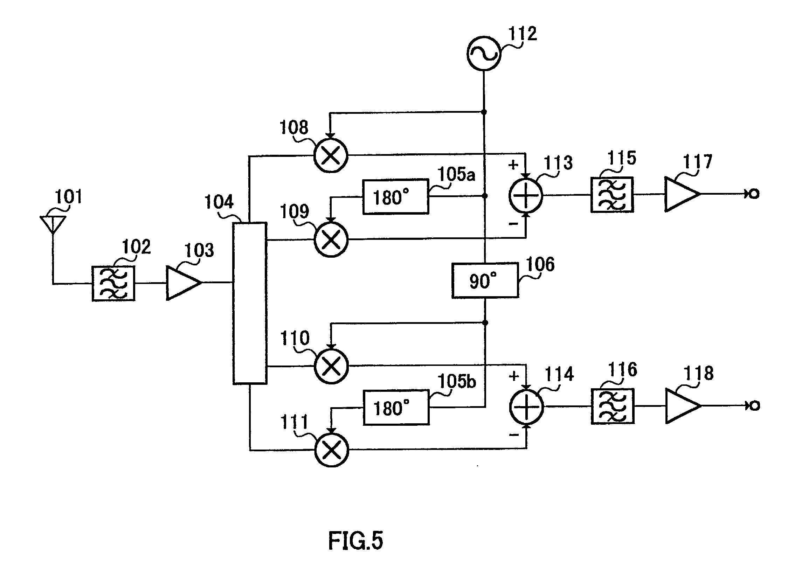

In the present embodiment, a case in which dispersion of the characteristics of the phase-shifters is suppressed by reducing the number of kinds of the used phase-shifters in embodiment 3 will be described. With reference to Fig. 5, a direct-conversion receiving apparatus according to the present embodiment will be described below.

FIG. 5 is a block diagram showing a configuration of the direct-conversion receiving apparatus according to embodiment 4 of the present invention. In FIG. 5, the components similar to those corresponding to embodiment 3 shown in FIG. 4 are assigned the same reference numerals and detailed descriptions thereof are omitted.

A phase-shifter 106 shifts by 90° the phase of a local signal outputted from a local oscillator 112 and outputs the local signal to both mixer 110 and phase-shifter 105b. The phase-shifter 105b shifts by 180° the phase of the local signal which has been shifted by 90° in the phase-shifter 106 and outputs the local signal to mixer 111.

Then, operation of the direct-conversion receiving apparatus having the above configuration will be described. In the present embodiment, the detailed description of the operations similar to those of embodiment 1 will be omitted.

The local signal which has been generated in the local oscillator 112 is outputted to mixer 110 after being shifted by 90° in the phase-shifter 106 whereas it is outputted to mixer 111 after being phase shifted by 90° in the phase-shifter 106 and further being phase shifted by 180° in the phase-shifter 105b. Thereby, there is an anti-phase relation between the local signal inputted to mixer 110 and the local signal inputted to mixer 111. Detailed description of the remaining operations is omitted as the operations excluding the above one are similar to those of the aforementioned embodiment 3.

According to the present embodiment, deterioration of the error rate characteristics caused by the DC offsets and unnecessary emission from the antenna may be prevented, and deterioration of the characteristics of received signals caused by the dispersion of the characteristics in phase-shifters may be suppressed in comparison with embodiment 3 in which three kinds of phase-shifters have been used, only two kinds of phase-shifters for phase-shifting by 90° and 180° have been used in embodiment 4.

### (Embodiment 5)

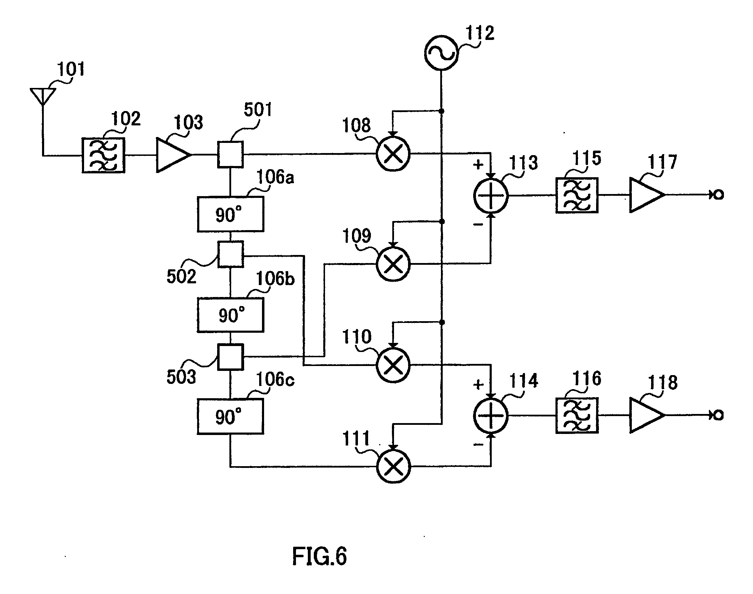

In the present embodiment, there will be described a case in which a reduction of the dispersion of the characteristics of the phase-shifters used in embodiment 1 is further reduced more than that of embodiment 2. With reference to Fig. 6, a direct-conversion receiving apparatus according to the present embodiment will be described below.

FIG. 6 is a block diagram showing a configuration of the direct-conversion receiving apparatus according to embodiment 5 of the present invention. In Fig.6, the components similar to those corresponding to embodiment 1 shown in FIG. 2 are assigned the same reference numerals and detailed descriptions thereof are omitted.

A power dividing unit 501 divides an RF signal amplified in an RF amplifier 103 into two signals and outputs the divided RF signals to both mixer 108 and phase-shifter 106a. The phase-shifter 106a shifts by 90° the phase of the RF signal from the power dividing unit 501 and outputs the RF signal to a power dividing unit 502.

The power dividing unit 502 divides the RF signal after being 90° phase-shifted into two signals and outputs the divided RF signals to both mixer 110 and phase-shifter 106b. The phase-shifter 106b shifts by 90 degrees the phase of the RF signal which has been shifted by 90° and outputs the RF signal to a power dividing unit 503.

The power dividing unit 503 divides the RF signal after being phase-shifted by a total of 180° into two signals and outputs the divided RF signals to both mixer 109 and phase-shifter 106c. The phase-shifter 106c shifts further by 90° the phase of the RF signal which has been shifted by 180° and outputs the RF signals to mixer 111.

Then, operation of the direct-conversion receiving apparatus having the above configuration will be described. In the present embodiment, the detailed description of the operations similar to those of embodiment 1 will be omitted.

The RF signal amplified in the RF amplifier 103 is divided into two signals (hereinafter, referred to as "eleventh RF signal" and "twelfth RF signal") in the power dividing unit 501. The eleventh RF signal is outputted to mixer 108 whereas the twelfth RF signal is outputted to phase-shifter 106a.

The twelfth RF signal is divided into two signals (hereinafter, referred to as "thirteenth RF signal" and "fourteenth RF signal" ) in the power dividing unit 502 after being phase shifted by 90° in the phase-shifter 106a. The thirteenth RF signal is outputted to mixer 110 whereas the fourteenth RF signal is outputted to phase-shifter 106b.

The fourteenth RF signal is divided into two signals (hereinafter, referred to as "fifteenth RF signal" and "sixteenth RF signal") in the power dividing unit 503 after being phase shifted by 90° in phase-shifter 106b (i.e., after 180° phase-shifting of the eleventh RF signal). The fifteenth RF signal is outputted to mixer 109 whereas the sixteenth RF signal is outputted to phase-shifter 106c.

The sixteenth RF signal is outputted to mixer 111 after being phase shifted by 90 degrees in the phase-shifter 106c (i.e., after 270° phase-shifting of the eleventh RF signal).

The eleventh RF signal and fifteenth RF signal are processed in mixers 108 and 109, respectively, in a similar manner to that of the embodiment 1. Here, there is an anti-phase relation between the eleventh RF signal inputted to mixer 108 and fifteenth RF signal inputted to mixer 109, in a similar manner to that of embodiment 1.

The thirteenth RF signal and sixteenth RF signal are processed in mixers 110 and 111, respectively, in a similar manner to that of embodiment 1. Here, there is an anti-phase relation between the thirteenth RF signal inputted to mixer 110 and sixteenth RF signal inputted to mixer 111, in a similar manner to that of the embodiment 1.

According to the above configuration, an I-ch baseband signal is generated in an adder 113 by in-phase addition of the first baseband signal and second baseband signal. A Q-ch baseband signal is generated in an adder 114 by in-phase addition of the third baseband signal and fourth baseband signal.

Moreover, a local signal which has leaked to mixer 108 reaches the power dividing unit 501 without phase-shifting. A local signal which has leaked to mixer 109 reaches the power dividing unit 501 after being phase shifted by a total of 180° withtwophase-shifters 106b and 106a. Therefore, the local signal from mixer 108 and the local signal from mixer 109 cancel each other by their addition in the power dividing unit 501 as there is an anti-phase relation between them at the time when they reach the power dividing unit 501.

Similarly, a local signal which has leaked to mixer 110 reaches the power dividing unit 501 after being phase shifted by 90° in the phase-shifter 106a. A local signal which has leaked to mixer 111 reaches the power dividing unit 501 after being phase shifted by a total of 270° in three phase-shifters 106c, 106b and 106a. Therefore, the local signal from mixer 110 and local signal from mixer 111 cancel each other by their addition in the power dividing unit 501 as there is an anti-phase relation between them at the time when they reach the power dividing unit 501. Accordingly, unnecessary emission from an antenna caused by the leakage of local signals may be remarkably suppressed.

Moreover, even if DC offsets are generated in mixers 108-111, DC offsets generated in both I-ch baseband signal and Q-ch baseband signal cancel each other based on the same reason as that of embodiment 1.

According to the present embodiment, deterioration of the error rate characteristics caused by the DC offsets and unnecessary emission from the antenna may be prevented, and deterioration of the received signals characteristics which has been caused by the dispersion of the characteristics of the phase-shifters may be suppressed. In comparison with not only embodiment 1 in which three kinds of phase-shifters have been used but also embodiment 2 in which two kinds of phase-shifters have been used, in the present embodiment, only one kind of phase-shifter for 90° phase-shifting is used.

### (Embodiment 6)

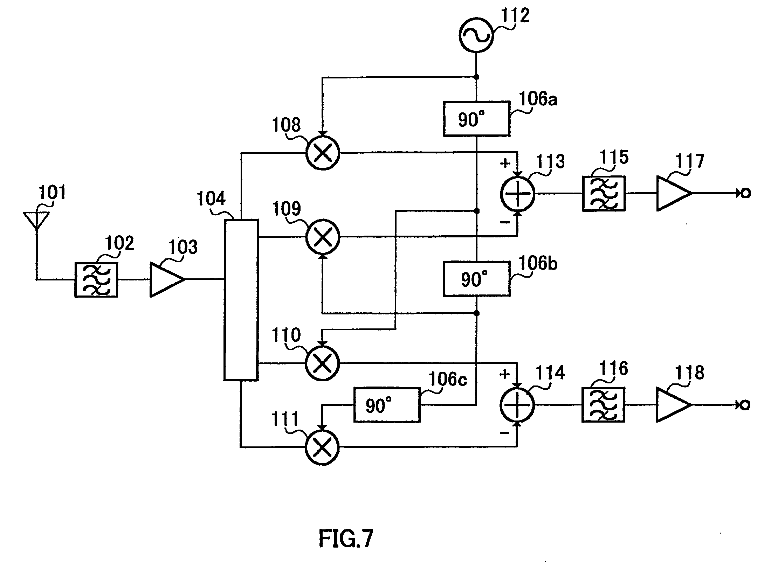

In the present embodiment, there will be described a case in which a reduction of the dispersion of the characteristics of the phase-shifters used in embodiment 3 is further reduced more than that of embodiment4. With reference to FIG. 7, a direct-conversion receiving apparatus according to the present embodiment will be described below.

FIG. 7 is a block diagram showing a configuration of the direct-conversion receiving apparatus according to embodiment 6 of the present invention. In FIG. 7, the components similar to those corresponding to embodiment 3 shown in FIG. 4 are assigned the same reference numerals and detailed descriptions thereof are omitted.

A phase-shifter 106a shifts by 90° the phase of a local signal outputted from a local oscillator 112 and outputs the local signal to both mixer 110 and phase-shifter 106b. A phase-shifter 106b shifts further by 90° the phase of the local signal which has been shifted by 90° in the phase-shifter 106a (i.e., the phase of the local signal generated in the local oscillator 112 is shifted by a total of 180°) and outputs the local signal to both mixer 109 and phase-shifter 106c. A phase-shifter 106c shifts further by 90° the phase of the local signal which has been shifted by a total of 180° in the phase-shifter 106b (i.e., the phase of the local signal generated in the local oscillator 112 is shifted by a total of 270°) and outputs the local signal to mixer 111.

Then, operation of the direct-conversion receiving apparatus having the above configuration will be described. In the present embodiment, the detailed description of the operations similar to those of embodiment 3 will be omitted.

The local signal generated in the local oscillator 112 is outputted to both mixer 108 without phase-shifting and to mixer 110 after being phase shifted by 90° in the phase-shifter 106a. Moreover, the local signal generated in the local oscillator 112 is outputted to mixer 109 after being phase shifted by a total of 180° in two phase-shifters 106a and 106b and then outputted to mixer 111 after being phase shifted by a total of 270° in three phase-shifters 106a, 106b and 106c.

The mixer 108 mixes the first RF signal and local signal after no phase-shifting whereas mixer 109 mixes the second RF signal and local signal after being 180° phase-shifted. Thereby, a first baseband signal and second baseband signal are generated, respectively. There is an anti-phase relation between the first baseband signal and second baseband signal.

Moreover, the mixer 110 mixes the third RF signal and local signal after being 90° phase-shifted whereas mixer 111 mixes the fourth RF signal and local signal after being 270° phase-shifted. Thereby, a third baseband signal and fourth baseband signal are generated, respectively. There is an anti-phase relation between the third baseband signal and fourth baseband signal.

In adder 113, an I-ch baseband signal is generated by in-phase addition of the first baseband signal and second baseband signal, as described in embodiment 3. Similarly, in adder 114, a Q-ch baseband signal is generated by in-phase addition of the third baseband signal and fourth baseband signal.

Furthermore, Since there is an anti-phase relation between the local signal inputted to mixer 108 and local signal inputted to mixer 109 , then, at the time when the local signal which has leaked to mixer 108 and local signal which has leaked to mixer 109 reach a power dividing unit 104there is an anti-phase relation between them, accordingly, both of the leaked local signals cancel each other by their addition in the power dividing unit 104.

Similarly, as there is an anti-phase relation between the local signal inputted to mixer 110 and local signal inputted to mixer 111 , then, at the time when the local signal which has leaked to mixer 110and local signal which has leaked to mixer 111 reach the power dividing unit 104 there is an anti-phase relation between them, accordingly, both of the leaked local signals cancel each other by their addition in the power dividing unit 104. Therefore, unnecessary emission from an antenna caused by the leakage of local signals may be remarkably suppressed.

Moreover, even if DC offsets are generated in mixers 108-111, DC offsets generated in both I-ch baseband signal and Q-ch baseband signal cancel each other based on the same reason as that of embodiment 3. Hence, deterioration of the error rate characteristics caused by DC offsets may be remarkably prevented.

According to the present embodiment, deterioration of the error rate characteristics caused by DC offsets and unnecessary emission from the antenna may be prevented, and deterioration of the received signals characteristics which has been caused by the dispersion of the characteristics of the phase-shifters may further be suppressed. In comparison with not only embodiment 3 in which three kinds of phase-shifters have been used but also with embodiment 4 in which two kinds of phase-shifters have been used, in the present embodiment, only one kind of phase-shifter for 90° phase-shifting is used.

### (Embodiment 7)

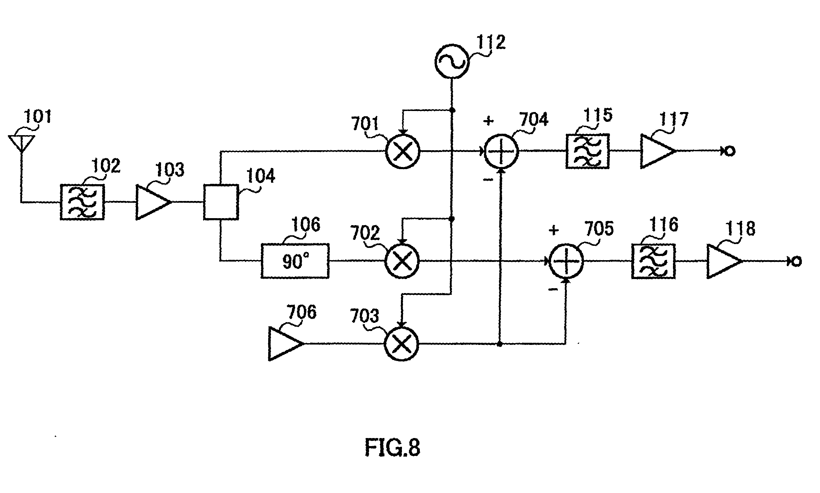

In the present embodiment, a case in which the circuit size is further reduced in comparison with that of embodiments 1 through 6 will be described with reference to FIG. 8.

FIG. 8 is a block diagram showing a configuration of a direct-conversion receiving apparatus according to embodiment 7 of the present invention. In FIG. 8, the components similar to those corresponding to embodiment 1 shown in FIG. 2 are assigned the same reference numerals and detailed descriptions thereof are omitted.

A phase-shifter 106 shifts the phase of an RF signal outputted from a power dividing unit 104 by 90° and outputs the RF signal to mixer 702. A mixer 701 generates an I-ch baseband signal by frequency conversion of the RF signal from the power dividing unit 104 into a baseband through mixing the RF signal from the power dividing unit 104 and the local signal from a local oscillator 112. Similarly, the mixer 702 generates a Q-ch baseband signal by frequency conversion of the RF signal from the power dividing unit 104 into a baseband through mixing the RF signal from power dividing unit 104 and a local signal from local oscillator 112.

On the other hand, the RF amplifier 706 has a similar configuration to that of an RF amplifier 103 described in embodiment 1. A mixer 703 generates a DC offset by mixing the local signal from local oscillator 112 and a signal which is caused by the leakage of local signal and is inputted to mixer 703 after being reflected at the RF amplifier and outputs them to adders 704 and 705.

The adder 704 subtracts the DC offset generated in mixer 703 from the I-ch baseband signal generated in mixer 701. While, the adder 705 subtracts the DC offset generated in mixer 703 from the Q-ch baseband signal generated in mixer 702.

Then, operation of the direct-conversion receiving apparatus having the above configuration will be described. In the present embodiment, the detailed description of the operations similar to those of embodiment 1 will be omitted.

An RF signal amplified in the RF amplifier 103 is divided into two RF signals (hereinafter, referred to as "seventeenth RF signal" and "eighteenth RF signal) in the power dividing unit 104. The seventeenth RF signal is outputted to mixer 701 whereas eighteenth RF signal is outputted to phase-shifter 106. The eighteenth RF signal is outputted to mixer 702 after being phase shifted by 90°.

The mixer 701 mixes the seventeenth RF signal and local signal outputted from the local oscillator 112. Thereby, the seventeenth RF signal becomes an I-ch baseband signal after frequency conversion into a baseband. Similarly, mixer 702 mixes the eighteenth RF signal after being 90° phase-shifted and local signal outputted from the local oscillator 112. Thereby, the eighteenth RF signal becomes a Q-ch baseband signal after frequency conversion into a baseband. Here, it is obvious that there is a phase difference of 90° between the I-ch baseband signal and Q-ch baseband signal since the phase of the eighteenth RF signal is shifted by 90°.

On the other hand, the local signal generated in the local oscillator 112 is also inputted to mixer 703. This local signal leaks to an RF port of mixer 703 (a port at the side of the RF amplifier 706). The leaked local signal is inputted to mixer 703 again after reflection at the RF amplifier 706. As a result, the mixer 703 mixes the local signal which has been generated in the local oscillator 112 and the reflected leaked local signal. Thereby generation of the DC offsets as self detection is performed in mixer 703. The generated DC offsets are outputted to adders 704 and 705.

The DC offset generated in mixer 703 is subtracted from the I-ch baseband signal generated in mixer 701 in the adder 704. Moreover, DC offset generated in mixer 703 is subtracted from the Q-ch baseband signal generated in mixer 702 in the adder 705. Thereby, adders 704 and 705 which have cancelled the DC offsets output the I-ch baseband signal and Q-ch baseband signal to low-pass filters 115 and 116, respectively. Thereby, deterioration of the error rate characteristics caused by the DC offsets may be remarkably suppressed. Here, measures of the antenna unnecessary emission have not been considered in the present embodiment.

According to the present embodiment, however, I-ch and Q-ch baseband signals from which the DC offsets have been cancelled may be generated by subtracting the DC offsets which have been compulsorily generated through usual generation of the I-ch and Q-ch baseband signals. Moreover, the circuit size might be reduced as only three mixers have been used according to the present embodiment in comparison with that of embodiments 1 through 6 which have used four mixers.

### (Embodiment 8)

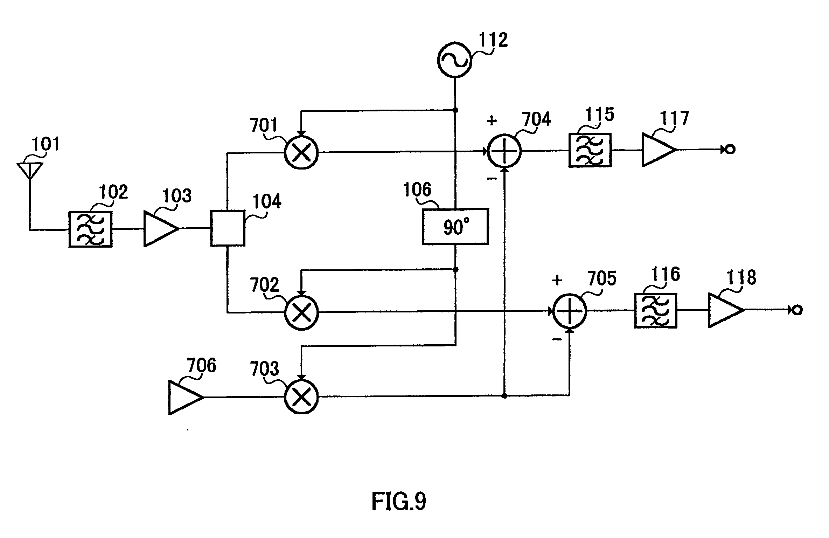

In the present embodiment, there will be described, referring to FIG. 9, a case in which the phase of a local signal is shifted instead of phase-shifting the RF signal as in embodiment 7.

FIG. 9 is a block diagram showing a configuration of the direct-conversion receiving apparatus according to embodiment 8 of the present invention. In FIG. 9, the components similar to those corresponding to embodiment 7 shown in FIG. 8 are assigned the same reference numerals and detailed descriptions thereof are omitted.

The direct-conversion receiving apparatus according to the present embodiment has a configuration in which a phase-shifter 106 in a direct-conversion receiving apparatus corresponding to embodiment 7 is provided between a local oscillator 112 and a mixer 702.

Then, operation of the direct-conversion receiving apparatus having the above configuration will be described. In the present embodiment, the detailed description of the operations similar to those of embodiment 7 will be omitted.

A seventeenth RF signal is outputted to mixer 701 whereas an eighteenth RF signal is outputted to mixer 702. Similar operations to those of embodiment 7 are performed in mixer 701, and an I-ch baseband signal is generated. The mixer 702 mixes both eighteenth RF signal and local signal after being 90° phase-shifted in the phase-shifter 106, hence, a Q-ch baseband signal is generated.

Here, it is obvious that there is a phase difference of 90° between I-ch baseband signal and Q-ch baseband signal as the eighteenth RF signal and local signal after being 90° phase-shifted are mixed.

According to the present embodiment in which the phases of the local signals have been shifted instead of phase-shifting of the RF signals, deterioration of the error rate characteristics caused by the DC offsets may be prevented, and deterioration of the receiving quality characteristics which has been caused by phase-shifting of RF signals and complex processing may be prevented in comparison with embodiment 7 in which the phases of the RF signals have been shifted.

The direct-conversion receiving apparatus according to the above embodiments can be installed in both communication terminal apparatus and base station apparatus of various kinds of digital mobile radio communication systems such as a CDMA (Code Division Multiple Access) system and an OFDM (Orthogonal Frequency Division Multiplexing) system.

The present application is based on the prior Japanese Patent Application 2000-256764 filed on August 28, 2000. The entire contents of which are incorporated herein by reference.

### Industrial Applicability

The present invention may be applied for a receiving apparatus using a direct-conversion receiving method in which a received frequency is directly converted into a baseband frequency.

## Claims

1. A direct-conversion receiving apparatus comprising:
dividing means for dividing a high frequency signal received through an antenna into two signals, a first signal and a second signal;
converting means for generating a first baseband signal from the first signal and a second baseband signal from the second signal, respectively, by frequency conversion of the first signal and the second signal using local signals with the same frequency as that of each of the first signal and the second signal so that there is an anti-phase relation between the first baseband signal and the second baseband signal; and
adding means for generating a baseband signal of a predetermined channel by taking a difference between the first baseband signal and the second baseband signal.

2. The direct-conversion receiving apparatus according to claim 1, wherein said converting means performs said frequency conversion by making a phase difference between the first signal and the second signal in an anti-phase state, and making a phase difference between a local signal used for the first signal and a local signal used for the second signal in an in-phase state.

3. The direct-conversion receiving apparatus according to claim 1, wherein said converting means performs said frequency conversion by making a phase difference between a local signal used for the first signal and a local signal used for the second signal in an anti-phase state, and making a phase difference between the first signal and the second signal in an in-phase state.

4. The direct-conversion receiving apparatus according to any one of claims 1 through 3, wherein said converting means comprises a plurality of phase-shifting means for shifting a phase of a signal by a respective predetermined phase difference, and wherein phases of the first signal, the second signal and/or the local signal are shifted by said plurality of phase-shifting means.

5. A direct-conversion receiving apparatus comprising:
converting means for generating a baseband signal of a predetermined channel by frequency conversion of a high frequency signal received through an antenna using a local signal with the same frequency as that of the high frequency signal;
generating means for compulsory generating DC offset using the local signal; and
adding means for subtracting the DC offset from the baseband signal of a predetermined channel.

6. A communication terminal apparatus comprising the direct-conversion receiving apparatus according to any one of claims 1 through 5.

7. A base station apparatus comprising the direct-conversion receiving apparatus according to any one of claims 1 through 5.

8. A direct-conversion receiving method comprising:
a dividing step for dividing a high frequency signal received through an antenna into two signals, a first signal and a second signal;
a converting step for generating a first baseband signal from the first signal and a second baseband signal from the second signal, respectively, by frequency conversion of the first signal and the second signal using local signals with the same frequency as that of each of the first signal and the second signal so that there is an anti-phase relation between the first baseband signal and the second baseband signal ; and
an adding step for generating a baseband signal of a predetermined channel by taking a difference between the first baseband signal and the second baseband signal.

9. A direct-conversion receiving method comprising:
a converting step for generating a baseband signal of a predetermined channel by frequency conversion of a high frequency signal received through an antenna using a local signal with the same frequency as that of the high frequency signal;
a generating step for compulsory generating DC offset using the local signal; and
an adding step for subtracting the DC offset from the baseband signal of a predetermined channel.
